# EUROPEAN PATENT APPLICATION

(11) **EP 0 631 220 A2**
(43) Date of publication of application: **28.12.1994**
(21) Application number: 94303500.6
(22) Date of filing: 16.05.1994
(51) Int. Cl.: G05D 23/20, G05D 23/19

(54) **Signals and method for controlling temperature of an electrical circuit**

(30) Priority: 22.06.1993 US 80698
(71) Applicant: ADVANCED MICRO DEVICES INC., Sunnyvale, California 94088-3453 (US)
(72) Inventor: Mudgett, Dan S., Austin, Texas 78749 (US)
(74) Representative: Wright, Hugh Ronald

(57) **Abstract**

A thermal sensor mechanism which controls the operation of a logic circuit to maintain the logic circuit at appropriate temperature. The thermal sensor mechanism includes a thermal sensor incorporated at a junction of the logic circuit to detect the temperature at the junction. The mechanism also includes a temperature feedback signal indicative of the temperature sensed by the thermal sensor at the junction. The temperature feedback signal is an input to a clock divider circuit of the mechanism. The clock divider circuit also receives an input clock signal and then outputs an output clock signal of frequency dictated by the clock divider circuit based upon the temperature feedback signal received by the clock divider circuit. The output clock signal serves as an input to drive the logic circuit.

## Description

The invention relates to a system and method for detecting the temperature of, for example, part of a circuit and delivering a desired clock signal to drive the circuit based on the temperature detected, for example a system that detects temperature at a location within a circuit and responds with desired control signals which dictate the frequency of clock signals driving the circuit in order to allow fastest possible operation of the circuit within particular temperature conditions appropriate for the circuit's operation.

We will describe a system or method that detects circuit temperature and responds thereto with appropriate control signals which cause the mechanism to vary the frequency of a clock signal driving the circuit so as to maintain circuit temperature within appropriate operational limits while attaining fastest possible circuit performance. In effect, the system resolves excessive temperature problems which may result from increasing circuit operating frequency or when using a circuit in certain higher temperature environments. Previous techniques, in particular power management techniques, have proven helpful in limiting circuit power consumption, but those techniques do not directly limit operating temperature as necessary to avoid excessive temperature problems. The present system can prevent circuits operating under excessive temperatures and so is a significant improvement in circuit technology.

The present system is particularly effective in a C-MOS circuit but may also be advantageously applied in other applications. The system is particularly effective in a C-MOS circuit because the dynamic- power consumed by a C-MOS circuit is directly proportional to the average frequency of operation of the circuit; static power being very small. With static C-MOS circuits there is no static power within those circuits, i.e., that is, when the clock driving a Static C-MOS circuit is stopped, there is no path for any current flow, except for minimal flow such as due to leakage of transistors of the circuit. Power is thus consumed by a C-MOS circuit primarily only each time a node of the circuit is transitioned to a different signal level. In the process of node transition in C-MOS circuits, there is a certain amount of energy that is required to move the load capacitance of each affected node through a voltage. The total power consumed by C-MOS circuits is, therefore, proportionally related to the power required to transition all of the nodes of those circuits.

Operation frequency of a circuit can generally be increased at a cost of increased power consumption. Circuit operation speed is important in most applications of those circuits. There are factors, however, that limit the total power that may be consumed by a particular circuit for appropriate operation of the circuit. Those factors which limit the total power consumption by a particular circuit include the maximum allowable temperature at which the circuit may be satisfactorily operated. Because temperature of the circuit generally increases as the circuit's operation frequency is increased, the temperature limitations of a circuit also constrain the maximum operating frequency.

One approach to maintaining appropriate circuit temperature and increasing circuit speed without increasing power to, and thus temperature of, the circuit is to reduce the power consumed by the circuit. This may be done by minimizing the transitioning of each node of the circuit. Node transitioning in circuits can be minimized by standard techniques like blocking unnecessary signal transitions, such as by limiting transition of an address bus or data bus by maintaining the state of the bus until a new address or data is required. Other approaches to limiting power consumption by this type circuit may also be employed either alone or in conjunction with techniques for minimizing transitioning of nodes of the circuit. Those approaches may include, for example, reducing the node capacitance of the circuit's nodes by materials or designs employed in the circuit; stopping or slowing the circuit's driver clock at times when circuit activity is not necessary; selectively stopping clocks to portions of the circuit; and/or various other approaches.

Though effective in many instances to limit the occurrence of excessive circuit temperature, these power management techniques do not entirely eliminate the possibility of excessive circuit temperatures. Power management techniques are only partially effective in eliminating the possibility of excessive circuit temperatures because they all depend on circuit operating conditions that can not be guaranteed at all times.

Generally, the circuit clock consumes much of the power to a circuit. The power consumed by the circuit clock is often on the order of one half the total power consumed by the circuit. This is the case because the clock runs continuously at a constant frequency, regardless what other activity is occurring within the circuit, all other circuit activity being the result of clock transition. Several approaches to reducing power consumption by the circuit clock have been heretofore implemented with some success. One approach to reducing power consumption by the circuit clock has been to employ various techniques which reduce the size of the circuit necessary to accomplish a particular function, so that the circuit clock capacitance is reduced. The flip side of this approach of reducing circuit size by these techniques, however, has been that, even though a smaller size circuit per function may be provided, greater numbers of functions may now be included in each particular integrated circuit. Including greater numbers of functions per circuit is advantageous, at least in part, because manufacturing costs can typically be lowered. Circuits themselves, though smaller per function due to the various techniques, are, therefore, becoming overall larger. The total power necessary to operate these circuits then continues to increase due to the increased size of the circuits, and temperatures of the circuits during operation likewise increase with the increasing power.

Temperature limits applicable to a particular circuit are dependent upon several factors. One factor is the maximum permissible junction temperature for the particular circuit. Excess junction temperatures may cause a circuit to function improperly. A variety of parameters may determine the maximum allowable junction temperature for a particular circuit. For example, transistors of the circuit may deteriorate above a certain temperature. Further, plastic packaging, for example, that often used in C-MOS circuits, may experience chemical change and loss of desirable characteristics when subjected to excessive temperatures. These and other parameters may dictate certain temperature limitations that must not be exceeded in a particular instance. It would be an advantage in the art if the circuit's operating temperature could be maintained so as not to ever exceed the maximum permissible junction temperature for the circuit.

Another factor affecting temperature limits for a circuit is limitations of present circuit testing practices. In particular, present circuit testing procedures normally allow for testing of circuits only over a limited range of temperatures, eitherdue to the maximum allowable junction temperature factor previously described or for other reasons. If in actual operation a circuit's temperature exceeds or is otherwise outside the range of the normal testing temperatures, then the circuit may tend to operate in a manner not compatible with the testing. For example, the operation of C-MOS and similar circuits tends to slow as temperature increases. This slowed operation can result in reliability problems, as testing may not detect whether the circuit will correctly or satisfactorily operate in a particular application involving increasing or excessive temperatures. It would be advantageous to eliminate the possibility that a circuit will be subject to operational temperatures that are in excess of the temperatures at which the circuit has been tested.

A further factor which affects temperature limitations for a circuit is the varied environmental temperature conditions in which the circuit may be operated in practice. Environmental temperature here refers to climactic and geographic conditions by which the circuit is surrounded and in which the circuit operates. It is desirable that a circuit be operable in a wide variety of environmental temperature conditions. It is often hard, if not impossible, however, to engineer a circuit operable under environmental conditions not completely known at the time of design. An example of such a situation is a circuit in a laptop computer. Most larger computers are operated only in an office environment, where it may be presumed in the design process that the computer will be operated in a room with air conditioning and forced cold air where temperature, humidity, and other environmental conditions are readily estimable. A laptop computer, on the other hand, may be operated in a variety of different environmental conditions at different times, which conditions may vary widely. For example, if the laptop is operated in an office environment, the environmental temperature can be presumed to be around 70-85°F; on the other hand, if the laptop is left in a car or in the sun, the computer may be subjected to temperatures in excess of 120°F. It is desirable that the laptop computer be immediately susceptible to operation in each and every of those widely variant environments. It would clearly be an advantage then if circuits of the laptop computer accounted for all those possible environmental temperature variations and were capable of operation in all those environments without loss of accuracy and function.

We will describe a thermal sensor mechanism for a circuit which compensates for all thermal conditions in which the circuit may be operated and thereby allows the circuit to operate at its maximum speed without exceeding temperature limitations of the circuit. The mechanism allows operation of a circuit over a broad range of thermal conditions, whether the thermal conditions result from the outside environment, the packaging, the circuit design, or any otherfactors. The mechanism is, thus, a significant improvement and advance in circuit technology.

According to one aspect, the present invention generally provides a thermal sensor mechanism that detects temperature at a location within a circuit and responds with desired control signals which dictate frequency of clock signals driving the circuit in order to allow fastest possible operation of the circuit within the particular temperature conditions appropriate for the circuit's operation.

In one aspect, the invention is a system that controls the temperature of a circuit driven by a circuit clock signal. The system comprises a means forsens- ing a temperature of the circuit, which means supplies a signal indicative of the temperature sensed, and a means for detecting the signal from the means for sensing and varying the circuit clock signal to the circuit based on the signal from the means for sensing in order to appropriately maintain circuit temperature.

In another aspect, the means for detecting includes a clock divider circuit which receives inputs of an input clock signal and the signal indicative of the temperature sensed by the means for sensing and outputs an output clock signal as the circuit clock signal to the circuit.

In yet another aspect, the means for sensing includes a temperature sensor which samples the temperature from time to time at a junction of the circuit.

In even another aspect, the means for sensing samples the temperature continuously.

In a further aspect, the means for detecting varies the circuit clock signal to the circuit to a lower frequency when the means for sensing samples that the temperature exceeds a threshold temperature.

In an even further aspect, the means for detecting varies the circuit clock signal to the circuit to a frequency equivalent to that of an input clock signal to the system when the means for sensing samples that the temperature is not greater than a threshold temperature.

In yet a further aspect, the circuit of the system is formed on a Silicon die and the means for sensing is incorporated as part of the die.

In another aspect, the circuit clock signal to the circuit has a frequency at least as high as that of the input clock signal unless the temperature sensed by the means for sensing exceeds a threshold temperature.

In yet another aspect, the circuit clock signal to the circuit has a frequency less than that of the input clock signal unless the temperature sensed by the means for sensing does not exceed a threshold temperature.

In another aspect, the means for sensing is incorporated with the circuit and samples the temperature at least one junction of the circuit.

In a further aspect, the circuit clock signal to the circuit is low frequency when the means for sensing samples that the temperature exceeds the threshold temperature and is otherwise high frequency.

In even another aspect, the circuit clock signal to the circuit has a frequency lower than that of the input clock signal when the means for sensing samples that the temperature exceeds the threshold temperature.

In another aspect, the invention is a system for controlling temperature of a circuit. The system comprises a thermal sensor mechanism and a power management mechanism.

In yet another aspect, the thermal sensor mechanism includes a clock divider means and a thermal sensor/feedback means.

In a further aspect, the clock divider means is a clock divider circuit.

In another further aspect, the thermal sensor/feedback means includes a temperature sensor and a temperature feedback signal.

In another aspect, the invention is a system, integrated with a system logic circuit for controlling the circuit. The system receives input of an input clock signal, and the circuit receives input of a circuit clock signal of a frequency dictated by the system. It comprises a means for sensing a temperature of the circuit, a means for generating a temperature signal indicative of the temperature sensed by the means for sensing, and a means for receiving the temperature signal and generating the circuit clock signal having the frequency dictated by the system.

In yet another aspect, the frequency of the circuit clock signal is varied by the means for receiving and generating to maintain a circuit temperature of the circuit as desired.

In even another aspect, the frequency of the circuit clock signal is varied to lower frequency when the temperature detected by the means for sensing exceeds a threshold temperature and is varied to higher frequency when the temperature detected by the means for sensing is not in excess of the threshold temperature.

In yet another aspect, the higher frequency is equivalent to a frequency of the input clock signal.

In even another aspect, the higher frequency is programmable.

In an even further aspect, the lower frequency is programmable.

### BRIEF DESCRIPTION OF THE DRAWINGS

FIG. 1 is a simplified block diagram illustration depicting the thermal sensor mechanism of the present invention in use with a circuit; and
FIG. 2 is a simplified block diagram illustration depicting the thermal sensor mechanism of the present invention in use with a circuit with which some power management mechanism is also in use.

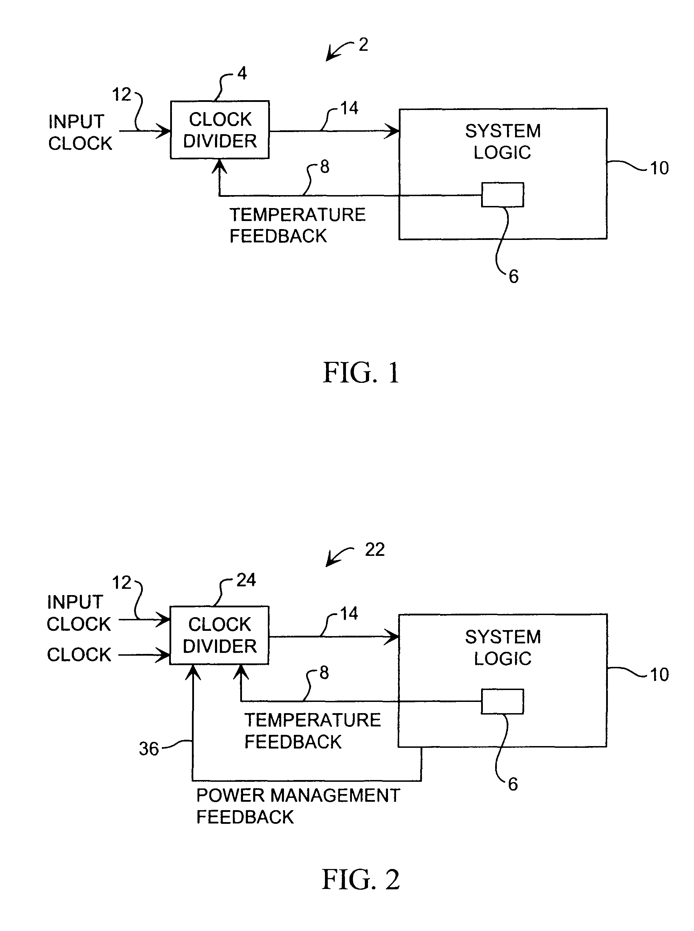

Like elements of the embodiments shown in FIG. 1 and FIG. 2 are sometimes designated by the same numbers in each of FIG. 1 and FIG. 2.

### DETAILED DESCRIPTION OF THE INVENTION

The following detailed description primarily addresses the preferred use of the present thermal sensor mechanism invention with a C-MOS circuit. Those skilled in the art will readily recognize, however, that the invention may be satisfactorily employed with a wide variety of circuits and under varied conditions, as well as in numerous other applications. The following detailed description also primarily addresses a preferred embodiment of the thermal sensor mechanism. Those skilled in the artwill, nevertheless, readily recognize that alternative aspects and embodiments of the invention are possible. All those other applications for and embodiments of the invention are hereby expressly included in, and form a part of, the invention.

Referring first to FIG. 1, the thermal sensor mechanism 2 of the present invention is seen to include essentially two elements: (1) a clock divider means and (2) a thermal sensor/feedback means. The clock divider means is comprised of a suitable clock dividing mechanism. The clock dividing mechanism must be capable of receiving input of a constant frequency clock signal and outputting, in response to appropriate control signals, an output signal of desired frequency, which is either the same as or different from (higher or lower) the frequency of the input signal depending upon the prescribed design and variables for the particular application.

Still referring to FIG. 1, the clock divider means is a clock divider circuit 4 in a preferred embodiment of the invention. The remaining portions of this detailed description may describe the invention in detail as including only this preferred clock divider circuit 4. All other suitable clock divider means which may function similarly to achieve the same results are, nevertheless, hereby expressly included in and form the invention.

Continuing to refer to FIG. 1, various clock divider mechanisms, like the clock divider circuit 4 of FIG. 1, are generally known to those skilled in the art. A clock divider circuit 4 functions by accepting a signal from a clock input 12 and then, depending upon the particular circuitry of the clock divider circuit 4, outputs an appropriate clock output signal 14. A wide variety of clock divider circuit 4 arrangements may be employed in the invention. In any case, however, the clock divider circuit 4 should function to respond with a desired clock output signal 14, dictated, at least in part, by the particular temperature feedback signal 8 which serves as an input control signal to the clock divider circuit 4.

Still referring to FIG. 1, the thermal sensor mechanism 2 of the present invention is seen to also include a thermal sensor/feedback means in addition to the clock divider means. In a preferred embodiment, the thermal sensor/feedback means includes a temperature sensor 6 and a temperature feedback signal 8. The temperature sensor 6 is employed to detect a temperature, for example, within a system logic circuit 10 where such a logic circuit 10 is being controlled by the thermal sensor mechanism 2. The temperature feedback signal 8 serves as an input control signal to the clock divider circuit 4, signalling the clock divider circuit to perform by outputting an appropriate clock output signal 14, which clock output signal 14 then serves to drive the logic circuit 10.

Continuing to refer to FIG. 1, the temperature sensor of the mechanism 2 may be incorporated, for example, into a system logic circuit 10 die of a logic circuit 10 which is to be regulated by the thermal sensor mechanism 2. Further, the temperature sensor 6 is preferably located at at least one particular, appropriate circuit junction (not shown in detail) of the system logic circuit 10. The temperature sensor 6, as so incorporated and located, serves to sample the temperature at the particular junction of the system logic circuit 10.

Continuing to refer to FIG. 1., in a preferred embodiment, the temperature sensor 6 is incorporated directly on a die of a circuit 10 being controlled by the mechanism 2. In this preferred arrangement, the temperature sensor 6 is, thus, an integral part of the silicon of the logic circuit 10 die and the junction measured by the temperature sensor 6 is actually right in the silicon of the logic circuit 10. Further, in a preferred embodiment the temperature sensor 6 is actually a diode built into the silicon and measures voltage across a biased diode. A wide variety of temperature sensor 6 mechanisms may be employed in the thermal sensor mechanism 2 of the present invention to achieve substantially the same results. All such designs are included in the invention.

Further referring to FIG. 1, the thermal sensor/feedback means of the thermal sensor mechanism 2 includes a temperature feedback signal 8 in addition to the temperature sensor 6. The temperature feedback signal 8 is an electrical signal indicative of the temperature sensed by the temperature sensor 6. The temperature feedback signal 8 travels from the temperature sensor 6 to the clock divider circuit 4 as an input to the clock divider circuit 4. Although particular aspects of the temperature sensor 6 and temperature feedback signal 8 may be varied according to the particular application, as will be recognized by those skilled in the art, the temperature sensor 6 in a preferred embodiment serves to sample a logic circuit 10 junction temperature on the order of 10 times per second. The sampling could, however, be at any interval, or even continuous.

Continuing to refer to FIG. 1, it is seen that the thermal sensor mechanism 2 of the present invention operates in the following manner. An input clock signal 12, which is a particularsingle orvariable frequency clock signal sufficient to drive the logic circuit 10, is delivered to the clock divider circuit 4. The clock divider circuit 4 then outputs an appropriate output clock signal 14 based upon the particular temperature feedback signal 8 then received by the clock divider circuit 4. The temperature feedback signal 8 then feeding the clock divider circuit 4 is dictated by the particular temperature then sampled by the temperature sensor 6 at the system logic circuit 10 junction at which the temperature sensor 6 is incorporated. If the temperature sensor then detects a junction temperature below a threshold temperature desired for the particular application, the temperature feedback signal 8 signals the clock divider circuit 4 to output as the output clock signal 14 the particular input clock signal 12. In that instance, the output clock signal 14 fed to the system logic circuit 10 (also sometimes referred to herein as the "circuit clock signal") will have the same frequency as the input clock signal 12. If on the other hand the temperature sensor 6 then detects a temperature of the system logic circuit 10 junction exceeding the particular threshold junction temperature desired for the application, the temperature sensor 6 causes the temperature feedback signal 8 fed to the clock circuit 4 to signal the clock divider circuit 4 to output a particular output clock signal 14 different from the particular input clock signal 12. In that instance, the output clock signal 14 fed to the system logic circuit 10 (i.e., the circuit clock signal) will have a different frequency from that of the input clock signal 12. The particular output clock signal 14 which is at any time output by the clock divider circuit 4 and input to the logic circuit 10 is in an appropriate manner, depending upon the design of the mechanism 2 and its desired operational characteristics, dictated by the temperature feedback signal 8.

Continuing still to refer to FIG. 1, although the clock dividercircuit 4 may be adapted according to the particular application, as those skilled in the art will readily appreciate, the clock divider circuit 4 may, as is the case in a preferred embodiment, cause the frequency of the output clock signal 14 to be slowed relative to the frequency of the input clock signal 12 when the temperature feedback signal 8 indicates that the temperature sensor 6 has detected a ju nction temperature of the logic circuit 10 in excess of the desired threshold for the logic circuit 10. For example, when the threshold junction temperature is exceeded and the temperature feedback signal 8 indicates to the clock divider circuit 4 that this is the case, the output clock signal 14 is slowed by several clock ticks, according to the mechanism 2 design and desired operational characteristics, relative to the input clock signal 12. As the output clock signal 14 continues to drive the system logic circuit 10 at a lower frequency than that of the input clock signal 12, the temperature sensor 6 continues to sample the junction temperature and feed a temperature feedback signal 8 to the clock divider circuit 4. The slowed output clock signal 14 allows the logic circuit 10 operation to slow, thereby lowering the temperature of the logic circuit 10.

Referring still to FIG. 1, so long as the junction temperature sampled by the temperature sensor 6 exceeds the desired threshold temperature for the logic circuit 10, the temperature feedback signal 8 fed to the clock divider circuit 4 continues the slowed output clock signal 14. Once the slowed output clock signal 14 driving the system logic circuit 10 slows the logic circuit 10 operation sufficiently to decrease the logic circuit 10 temperature such that the detected junction temperature falls below the desired threshold temperature for the logic circuit 10, the temperature sensor 6 then detects this lowered junction temperature and outputs a temperature feedback signal 8 indicative of that state. This temperature feedback signal 8 indicative of the junction temperature below the desired threshold temperature, when fed to the clock divider circuit 4, causes the clock divider circuit 4 to feed to the logic circuit 10 an output clock signal 14 of the same frequency as the frequency of the input clock signal 12. The output clock signal 14 under that circumstance is then of a higherfrequency than when the junction temperature exceeds the desired threshold temperature, and the system logic circuit 10 is driven accordingly at a higher speed causing temperature of the circuit 10 to rise.

Continuing to refer to FIG. 1, as is apparent, the clock divider means and thermal sensor/feedback means together form a control loop which allows a circuit, for example, a system logic circuit 10, to operate under at least two conditions, i.e., by the input clock signal 12 when a junction temperature sensed by the thermal sensor/ feedback means is below an appropriate threshold level and by a signal of frequency lower than that of the input clock signal 12, as dictated by the particular clock divider means, when the circuit junction temperature detected by the thermal sensor/feedback means exceeds that threshold level. This preferred control loop is a first order loop, responding only to change of the junction temperatures. Alternately a second or higher order loop, responding to rate of change of junction temperature and/or other parameters, could be used. Those skilled in the art will recognize that the thermal sensor mechanism 2 may be designed to operate according to a virtually unlimited set of operating parameters. Those parameters may be set by system design or may even be programmable or otherwise variable. The particular parameters, in any event, dictate the particular configuration and operation of the clock divider means, the thermal sensor/feedback means, and/or both, as well as the overall characteristics of the thermal sensor mechanism 2.

Those skilled in the art will recognize that what is herein described as a preferred embodiment may be the simplest possible arrangement of the thermal sensor mechanism 2 of the present invention, i.e., the clock divider circuit 4 will output as the output clock signal 14 eithera high frequency signal (i.e., the same as the input clock signal 12) or a low frequency signal (i.e., as desired for the particular application and governed by the particular mechanism configuration and parameters). In this simple arrangement of only two signal states from the clock divider means (i.e., either a high or low output signal frequency), the system logic circuit 10 will be driven by an average frequency input signal the output clock signal 14) that allows the logic circuit 10 to operate at, but not above, the par- ticularchosen threshold temperature. This is the case regardless of the factors which may dictate the logic circuit 10 junction temperature at any given time, whether those factors are inherent in or due to the system, the environment, or any other factors.

Those skilled in the art will also recognize that as an alternative to an either high or low output signal frequency arrangement, the clock divider means could provide any of a wide variety of filtered output clock signal 14 scenarios. For example, the filtering could allow for a stepped reduction of the output clock signal 14 frequency; a choice of particular output clock signal 14 frequency from some group of possibilities, for example, after the junction temperature has exceeded the desired threshold temperature and the output clock signal 14 has dropped to a lowerfre- quency signal, if the junction temperature then at a later detection time continues to exceed the particular threshold temperature, the filtering could be designed to cause the output clock signal 14 to drop to an even lower frequency signal; as well as numerous other variations. These and other virtually unlimited characteristics of the mechanism 2 are clearly possible, and all such possibilities are included in the invention.

In any arrangement of output clock signal 14 frequency change and timing for such change, the key in design and configuration will always be maximization of logic circuit 10 performance while maintaining the logic circuit 10 at temperatures that are within appropriate threshold temperatures.

Though not illustrated in detail in the figures, a large array of other embodiments of the invention is also possible. For example, the junction temperature within the system logic circuit 10 could be sampled by one or more temperature sensors 6 at more than one junction within the logic circuit 10. This type embodiment might be appropriate, for example, where the logic circuit 10 is large with varying temperature within the circuit and various aspects of the circuit 10 are highly dependent upon operation of the logic circuit 10 at or within specific temperatures for peak performance. In this instance, operating parameters and configurations of the thermal sensor mechanism 2 could be adapted to achieve the desired results for the application.

Another alternative embodiment of the present invention, also not illustrated in detail in the figures, could include variations upon the extent to which aspects of the thermal sensor mechanism 2 are incorporated in or with the system logic circuit 10 die. As previously described, the temperature sensor 6 in the preferred embodiment is incorporated directly in the system logic circuit 10 forming the circuit junction thereof. Alternatively, the temperature sensor 6 could be externally attached to the system logic circuit 10 and the clock divider means and/or thermal sensor/feedback means could also be either external or internal devices to the logic circuit 10.

In even further alternative embodiments which are also not illustrated in detail in the figures, the thermal sensor mechanism 2 may be designed to accord great flexibility in application. An example of an aspect of the mechanism 2 which may lend application flexibility includes programmability. As previously described, the mechanism 2 could be designed either to operate in accordance with fixed parameters or to allow programmability of the various parameters of the mechanism 2. In a preferred embodiment, programmable variables may include the maximum frequency of the output clock signal 14, a specified cool down output clock signal 14 frequency, various slowed frequencies, and total or partial shutdown of the logic circuit 10. In addition, numerous other programmable variables, for example, threshold temperature and others, could be incorporated in the design. Even further, the mechanism 2 could be programmed by an external source, for example, the BIOS of a PC. In such an environment, when the BIOS comes up, the power-on code could configure all variables for circuit operation, including those variables pertinent to operation of the thermal sensor mechanism 2. Other external or other sources for variable configuration for the mechanism 2 in a particular application will be understood to those skilled in the art. All those other variable configurations for the mechanism 2 are included in the invention.

In even another possible alternative embodiment of the thermal sensor mechanism 2, the mechanism 2 could include means for generating more than one output clock signal 14. In such a case, the clock divider circuit 4 and other elements of the mechanism 2 would be designed to operate under the particular desired conditions and within the applicable parameters. These multiple output arrangements could be generally operable according to the same or similar principles as herein more specifically described and so are also included in the invention.

Another situation might be where information is stored on a capacitor of a circuit 10, where the capacitor power will eventually bleed away. In that instance the mechanism 2 might be fed by multiple inputs. This type of circuit could include some dynamic nodes whereby the driver clock to the logic circuit 10 servicing those nodes could not be slowed or stopped. Possibly in these and numerous other instances that will be recognized by those skilled in the art, a multiple input to the thermal sensor mechanism 2 may be desirable. These multiple input arrangements for the mechanism 2 could be generally operable according to the same or similar principles as herein more specifically described and so are also included in the invention.

In an even further alternative arrangement of the thermal sensor mechanism 2 not illustrated in detail in the figures, the thermal sensor mechanism 2 could be integrated with a wide variety of other circuits and devices to achieve particular, desired functions. Other circuits and devices could include, for example, clock switcher circuits which provide for switching between any of a plurality of clocks which may, at any given time under the particular configuration, source a particular logic circuit 10 with which the mechanism 2 is employed. Numerous other alternative integration arrangements are possible, and, all of those arrangements are included in the invention.

Referring now to FIG. 2, one other possible alternative embodiment of the present invention is illustrated. In this particular alternative embodiment, the thermal sensor mechanism 2 of FIG. 1 is integrated with a power management mechanism. Awide variety of power management mechanisms are known and currently in use. These mechanisms often operate with peripheral devices to computers. They may be equipped to manage things like a floppy disk drive, a display, a keyboard, and other devices which may be controlled by a system logic circuit 10. Typically, power management mechanisms operate by shutting down a particular aspect or peripheral of a circuit 10 system when the aspect or peripheral has not been accessed for some length of time. An example of a common power management mechanism operating internally in a system is a mechanism which shuts off the floating point unit of the system circuit 10 for computations in which the unit is not needed. By shutting off the floating point unit, power, amounting to the power required to operate that unit, is saved when operating the system circuit 10. Since the floating point unit is not necessary to many commor operations of a system circuit 10, no loss of function or accuracy results, yet power is saved.

Continuing to refer to FIG. 2, in devices heretofore incorporating these various power management mechanisms, the power management mechanisms, although primarily intended to extend battery life, have, in some instances, also sufficiently maintained thermal conditions of related circuitry to guarantee appropriate system circuit operation. Though the power management mechanisms have at times proven effective for maintaining appropriate circuitry temperature conditions, utilization of power management mechanisms alone is generally not entirely effective in maintaining circuit 10 temperatures within desired ranges under all operating conditions. The present thermal sensor mechanism 2 is, on the other hand, effective to manage circuit 10 temperature in each and every possible instance. Therefore, it may be preferable, for example, as illustrated in FIG. 2, to incorporate in or with the same system logic circuit 10 both a thermal sensor mechanism 2 and one or more power management mechanisms.

Continuing to refer to FIG. 2, an integrated power/thermal management system 22 is illustrated. This system 22 is seen to comprise both the thermal sensor mechanism 2 of FIG. 1 and a power management mechanism, such as those previously described herein. The thermal sensor mechanism 2 (see FIG. 1) portion in this embodiment has essentially the same features of the embodiment in FIG. 1, i.e., both a clock divider means and a thermal sensor/feedback means. More particularly, this embodiment includes a clock divider circuit 24 which receives input of the input clock signal 12 and outputs a clock output signal 14. The clock divider circuit 24 may also accept input of various control signals, such as a temperature feedback signal 8 and/or a power management feedback signal 36 The clock divider circuit 24 is appropriately configured, in accordance with the principles heretofore described with respect to the embodiment in FIG. 1, to provide an appropriate clock output signal 14 based on the particular clock input signal 12, temperature feedback signal 8, and power management feedback signal 36 values at any instant.

Still referring to FIG. 2, the clock output signal 14 feeds a system logic circuit 10. The system logic circuit 10 is incorporated with both a temperature sensor 6, which, as in the case of the mechanism 2 shown in FIG. 1, is preferably incorporated in the system logic circuit 10 die and samples temperature at a circuit junction of the logic circuit 10. The system logic circuit 10 may also be equipped, either by incorporation or configuration therewith, with any of a variety of external devices which serve as power management detection mechanisms (not shown in detail in FIG. 2 but illustrated as generating a control signal described as a power management feedback signal 36) for detecting any of a broad assortment of variables indicative of power consumption by the various aspects of the system logic circuit 10 or of peripherals with which the system logic circuit 10 is equipped.

Continuing now to refer to FIG. 2, as with the thermal sensor mechanism 2 of FIG. 1, the temperature sensor 6 of this power/thermal management system 22 may be configured in a variety of ways, including, for example, as a multiple junction detection sensor. Even further variation is possible in the alternative embodiment illustrated in FIG. 2 than in that of FIG. 1 since the incorporated power management mechanisms could also or additionally be configured in a wide variety of manners. All variations are included in the invention.

Further referring to FIG. 2, the temperature sensor 6 of the power/thermal management system 22 delivers a temperature feedback signal 8 to the clock divider circuit 24. The power detection mechanism (not shown) delivers a power management feedback signal 36 to the clock divider circuit 24. These two signals 8, 36 provide the necessary inputs to the clock divider circuit 24 to enable the clock divider circuit 24 to output an appropriate output clock signal 14 to drive the logic circuit 10.

Still referring to FIG. 2, as with the simplified thermal sensor mechanism 2 of FIG. 1, numerous alternative embodiments are possible for the power/thermal management system 22 of FIG. 2. Many of the multitude of variations to the thermal sensor mechanism 2 of FIG. 1 will also be applicable to this power/thermal management system 22 since this system 22 includes, in part, the mechanism 2. Since this system 22 additionally includes power management mechanisms, however, the possible variations for configuration of the system 22, its variables, and its parameters, are clearly multiplicative of those possible when the thermal sensor mechanism 2 is employed alone. All those variations are included in the invention.

As is clearly seen, the present invention overcomes the excessive temperature problems presented by the prior technology. The present invention is believed to be especially effective when configured and employed as described herein, however, those skilled in the art will readily recognize that numerous variations and substitutions may be made in the invention and its use and configuration to achieve substantially the same results as achieved by the embodiments and, in particular, the preferred embodiments, expressly described herein. Each of those variations is intended to be included in the description herein and forms a part of the present invention. The foregoing detailed description is, thus, to be clearly understood as being given by way of illustration and example only, the spirit and scope of the present invention being limited solely by the appended claims.

## Claims

1. A system for controlling temperature of a circuit driven by a circuit clock signal, comprising:
a means for sensing a temperature of said circuit, said means supplying a signal indicative of said temperature sensed; and
a means fordetecting said signal from said means for sensing and varying said circuit clock signal to said circuit based on said signal from said means for sensing in order to appropriately maintain circuit temperature.

2. The system of claim 1, wherein said means for detecting is a clock divider circuit, said clock divider circuit receiving inputs of an input clock signal and said signal indicative of said temperature sensed by said means for sensing and outputting an output clock signal as said circuit clock signal to said circuit.

3. The system of claim 1, wherein said means for sensing is a temperature sensor which samples said temperature from time to time at a junction of said circuit.

4. The system of claim 1, wherein said means for detecting varies said circuit clock signal to said circuit to a lower frequency when said means for sensing samples that said temperature exceeds a threshold temperature.

5. The system of claim 1, wherein said means for detecting varies said circuit clock signal to said circuit to a frequency equivalent to that of an input clock signal to said system when said means for sensing samples that said temperature is not greater than a threshold temperature.

6. The system of claim 1, wherein said circuit is formed on a silicon die and said means for sensing is incorporated as part of said die.

7. The system of claim 2, wherein said circuit clock signal to said circuit has a frequency at least as high as that of said input clock signal unless said temperature sensed by said means for sensing exceeds a threshold temperature.

8. The system of claim 2, wherein said circuit clock signal to said circuit has a frequency less than that of said input clock signal unless said temperature sensed by said means for sensing does not exceed a threshold temperature.

9. The system of claim 3, wherein said means for sensing is incorporated with said circuit and samples said temperature at at least one junction of said circuit

10. The system of claim 4, wherein said circuit clock signal to said circuit is low frequency when said means for sensing samples that said temperature exceeds said threshold temperature and is otherwise high frequency.

11. The system of claim 7, wherein said circuit clock signal to said circuit has a frequency lower than that of said input clock signal when said means for sensing samples that said temperature exceeds said threshold temperature.

12. A system for controlling temperature of a circuit, comprising:
a thermal sensor mechanism; and
a power management mechanism.

13. The system of claim 12, wherein said thermal sensor mechanism includes a clock divider means and a thermal sensor/feedback means.

14. The system of claim 13, wherein said clock divider means is a clock divider circuit.

15. The system of claim 13, wherein said thermal sensor/feedback means includes a temperature sensor and a temperature feedback signal.

16. A system, integrated with a system logic circuit, for controlling said circuit, said system receiving input of an input clock signal, and said circuit receiving input of a circuit clock signal of a frequency dictated by said system, comprising:
a means for sensing a temperature of said circuit;
a means for generating a temperature signal indicative of said temperature sensed by said means for sensing; and
a means for receiving said temperature signal and generating said circuit clock signal having said frequency.

17. The system of claim 16, wherein said frequency of said circuit clock signal is varied by said means for receiving and generating to maintain a circuit temperature of said circuit as desired.

18. The system of claim 17, wherein said frequency of said circuit clock signal is varied to lower frequency when said temperature detected by said means for sensing exceeds a threshold temperature and is varied to higher frequency when said temperature detected by said means for sensing is not in excess of said threshold temperature.

19. The system of claim 18, wherein said higher frequency is equivalent to a frequency of said input clock signal.

20. The system of claim 18, wherein said higher frequency is programmable.

21. The system of claim 19, wherein said lower frequency is programmable.

22. The system of claim 1, wherein said means for sensing samples said temperature continuously.

23. A method for controlling an electronic circuit including a clock signal generator, comprising sensing the temperature of at least part of said electronic circuit and controlling the clock signal in accordance with said sensed temperature.

24. A method as claimed in claim 23 in which the frequency of the clock signal is controlled.

25. A method as claimed in claim 23 or 24 in which said clock signal is controlled when the sensed temperature exceeds a threshold value.

26. An electronic circuit comprising a clock signal generator and means for sensing the temperature of at least part of said electronic circuit, and means for controlling the clock signal provided by said clock signal generator in accordance with the temperature sensed by said sensing means.

27. An electronic circuit as claimed in claim 26 in which said control means controls the frequency of the clock signal provided by said clock signal generator.

28. An electronic circuit as claimed in claim 27 in which said sensing means controls the frequency of the clock signal output of said clock signal generator when the sensed temperature exceeds a threshold value.
